Europäisches Patentamt

European Patent Office

Office européen des brevets

(19)

(11) **EP 0 642 183 B1**

## (12) EUROPEAN PATENT SPECIFICATION

(45) Date of publication and mention
of the grant of the patent:
**25.03.1998  Bulletin 1998/13**

(51) Int Cl.[6]: **H01L 43/10**

(21) Application number: **94113807.5**

(22) Date of filing: **02.09.1994**

(54) **Magnetic material with zero magnetostriction**

Magnetisches Material mit Zero-Magnetostriktion

Matériau magnétique à magnétostriction zéro

(84) Designated Contracting States:
**DE FR GB NL**

(30) Priority: **02.09.1993  US 114629**

(43) Date of publication of application:
**08.03.1995  Bulletin 1995/10**

(73) Proprietor: **READ-RITE CORPORATION**
**Milpitas California 95035 (US)**

(72) Inventor: **Nepela, Daniel A.**
**San Jose, CA 95123 (US)**

(74) Representative: **Körber, Wolfhart, Dr. rer.nat. et al**
**Patentanwälte**
**Mitscherlich & Partner,**
**Sonnenstrasse 33**
**80331 München (DE)**

(56) References cited:
**EP-A- 0 412 071**          **US-A- 4 023 965**

- **JOURNAL OF APPLIED PHYSICS, SEPT. 1979, USA, VOL. 50, NR. 9, PAGE(S) 5899 - 5901, ISSN 0021-8979, RICE D W ET AL 'Properties of thin films of Permalloy with rhodium addition for corrosion resistance'**
- **RESEARCH DISCLOSURE, vol. 240, no.006, 10 April 1984 EMSWORTH, GB, ANONYMOUS 'Soft film biased magnetoresistive sensor - is made of nickel-iron permalloy contg. small amt. of rhodium'**

**Description**

FIELD OF THE INVENTION

This invention relates to thin films used in magnetic transducer heads and in particular to thin film ternary alloys of nickel, iron and rhodium having virtually zero magnetostriction.

BACKGROUND OF THE INVENTION

Magnetoresistive (MR) transducers are used to read data signals stored on magnetic media, such as magnetic disks. Soft magnetic materials used in MR transducers vary in composition. A preferred alloy consists of about 80% nickel (Ni) and about 20% iron (Fe). Alloys having this approximate Ni/Fe composition are commercially available under the trade name Permalloy. In order to reduce corrosion of Permalloy-like materials, other components have been incorporated into the Ni/Fe alloys. One additive which is particularly advantageous in enhancing Ni/Fe alloy corrosion resistance is rhodium (Rh).

When rhodium is incorporated into an Ni/Fe alloy, the magnetostriction of the alloy may be adversely affected. Specifically, as rhodium is incorporated into Ni/Fe (Permalloy type) alloys, the NiFe atomic ratio must be adjusted to maintain the magnetostriction at near zero levels. The requirement for near zero levels of magnetostriction arises from the fact that stress, either substrate induced or intrinsic stress or a combination thereof, in either the MR sensor and/ or the soft adjacent film used for transverse biasing of the active MR layer can adversely affect the domain configuration of the sensor or soft bias layer. Near zero magnetostriction in these layers minimizes or eliminates these adverse effects and thus results in a more reliable and reproducible sensor.

In US-A-4,023,965, Ni-Fe-Rh-alloys are disclosed whereby this document is concerned with corrosion resistance and not with magnetostriction.

SUMMARY OF THE INVENTION

An object of this invention is to provide nickel-iron-rhodium compositions having substantially no magnetostriction. Another object of this invention is to improve the corrosion resistance of nickel-iron alloys.

According to the invention as claimed in claim 1, soft magnetic alloys comprise NiFe having atomic ratios ranging from about 4.8 to 5.5. These alloys include an amount of rhodium that yield near zero saturation magnetostriction, i. e., within +0.5 to -1.0 x $10^{-6}$ $\Delta$l/l as defined by the following equation:

$$\text{Atomic \% Rh} = 11.63 \ (Ni/Fe) \text{ atomic ratio } -49.53 \text{ atomic percent}$$

According to the invention, an MR read transducer is formed with a soft magnetic layer including a nickel/iron/ rhodium alloy (claim 3). The composition of the soft magnetic layer is defined by the above-defined equation. Preferably, the soft magnetic material is positioned between hard magnetic end regions.

According to the invention there is provided a method of improving the corrosion resistance of a nickel-iron alloy while keeping the saturation magnetostriction within the limits of +0.50 -1.0 x $10^{-6}$ (claim 5). The method involves incorporating rhodium into a nickel-iron alloy in an amount defined by the aforementioned equation. We have found by experiment that when NiFe films containing rhodium of this invention are subjected to an acidic oxidizing etching solution containing hydrogen ions and hydrogen peroxide, the corrosion rate relative to Permalloy is reduced and follows the following equation:

$$\frac{\text{corrosion rate of NiFeRh}}{\text{corrosion rate NiFe}} = e^{-0.19(\text{atomic\%Rh})}$$

For example, a NiFeRh alloy, made in accordance with this invention, containing 10 atomic% rhodium etches at a rate of 0.0125 that of nominal 80:20 NiFe Permalloy.

BRIEF DESCRIPTION OF THE DRAWINGS

This invention will be described in further detail with reference to the accompanying drawing wherein:

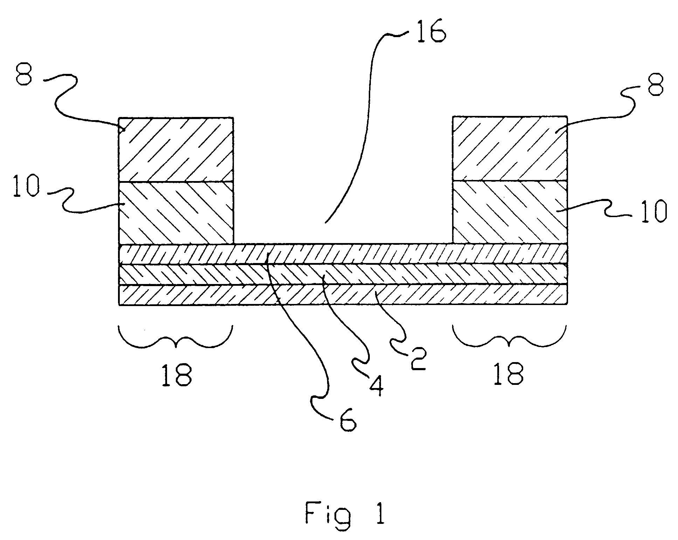

FIGURE 1 is a sectional view of a magnetoresistive read transducer having a soft active region.

DETAILED DESCRIPTION OF THE INVENTION

With reference to FIG.1, a magnetoresistive read transducer 20 is formed with a central active layer 16 that is composed of a soft active layer 2 separated from an MR layer 6 by a nonmagnetic spacer layer 4. Passive end regions 18 include a hard magnetic biasing layer 10 and a conductive layer 8. The central active region 16 is defined by the space between the passive end regions 18.

Data stored on a magnetic medium is sensed by the MR layer when an electrical DC current is passed through the transducer of Fig. 1. The electrical current also has the role of saturating the soft film layer 2 whose magnetic field places the active MR layer 6 at the optimum operating point of the MR active layer. The proper operating point of the MR sensor is achieved by satisfying the condition that the magnetic moment thickness product of the soft film bias layer 2 is approximately 0.5 to 0.7 that of the active MR layer 6. Additionally it is also desirable that the resistivity and/ or resistance of the soft film bias layer 2 be significantly greater than that of the active MR layer 6. Otherwise the efficiency or signal output of the device suffers and the signal-to-noise level is deleteriously affected. The soft bias layer of this invention, at 10 atomic% rhodium for example, has a resistivity about 4 times greater than that of the Permalloy MR sensor. Accordingly, an improved signal-to-noise ratio is achieved simultaneously with zero magnetostriction with a resultant significant improvement in corrosion resistance.

The transducer includes a means of generating a longitudinal bias. FIG. 1 shows passive end regions 18 which provide longitudinal biasing. End regions 18 include a hard magnetic bias layer 10 and a conductive layer 8. The hard magnetic biasing layer may be composed of a single layer of material, such as an alloy of cobalt-chromium, cobalt-platinum, or cobalt-chromium-platinum. Alternatively, an undercoating or overcoating with tungsten or gold may be used. Although the preferred longitudinal biasing means involves end regions having a hard magnetic biasing layer and a conductive layer, other embodiments which provide means for generating longitudinal bias without hard biasing end regions may be used.

The compositions and thicknesses of the MR transducer trilayer, i.e., the magnetoresitve layer 6, the spacer layer 4, and the soft active layer 2, depends on the specific application. The spacer layer 4 may be a conducting or insulating material, but preferably is an insulating or nonmagnetic material. The magnetoresistive layer 6 and soft active layer 2 range from 5 to 80 nm (50 to 800 Angstroms) in thickness. The soft active layer 2 is preferably composed of a tricomponent alloy of nickel, iron, and rhodium, whereas the magnetoresistive layer is typically 81/19 NiFe. Although the atomic percentages of nickel and iron may vary depending on the application, the preferred atomic percentage of nickel for the soft layer 2 is in the range of about 4.79 to 5.58 reflecting a range of approximately 6-15 atomic % Rh as defined by:

$$\text{Atomic \% Rh} = 11.63 \, (\text{NiFe}) \text{ atomic ratio } -49.53$$

The calculation of iron, nickel and rhodium for a soft magnetic material may be best understood from an example. For instance, for an alloy having a Ni/Fe ratio of 5, the most preferred atomic percent rhodium is about 8.4%. The fixing of the Ni/Fe ratio at 5 and the rhodium concentration at 8.4% fixes the concentration of nickel and iron. Thus, in this example, the atomic percent nickel is (100-8.5)*5/6, or about 76.3%, while the balance of iron is (100-76.3-8.5), or 15.3%.

The transducer 20 may be formed by methods known in the art. A process of forming the transducer is described U.S. Patent No. 5,018,037 (See columns 3-4 and FIGS. 3-5), which is hereby incorporated by reference. The transducer thin films may be deposited, for example, by sputter coating techniques, such as ion beam sputtering. Preferably, substrate temperatures are maintained relatively uniform and may range from room temperature to about 300 degrees Centigrade. Argon chamber pressures during deposition may range from 5 milliTorr to about 4 Pa (30 milliTorr) with a preferred range of about 1.33 - 2 Pa (10-15 milliTorr).

EXAMPLE

A ternary alloy of nickel, iron, and rhodium was sputter deposited onto a 25 mil thick silicon wafer and 0.50 micron $Al_2O_3$ and 100 Angstrom Ta overcoat. Deposition was accomplished using a Perkins Elmer 2400 and using a specific nickel-iron-rhodium target source available from ACI Alloys, San Jose, CA. The substrate was held at a temperature of about 50 degrees Centigrade. The deposition chamber was maintained at a pressure of about 2 Pa (15 milliTorr) in an Argon atmosphere. The base pressure prior to Argon was less than $6.7 \times 10^{-5}$ Pa ($5 \times 10^{-7}$ Torr). The deposition rate was about $1.5 \times 10^{-8}$ m (150 Angstroms) per minute. A film of about $6.4 \times 10^{-8}$ m (640 Angstroms) thickness was formed. Film thickness was determined by a step technique using a Tencor Profilemeter available from Tencor, Mountain View, CA. The resultant film had the following atomic percent composition: 75.3% Ni, 14.7% Fe, and 10.0% Rh. Compositions were determined by target composition. The film's saturation magnetostriction was measured by laser-cantilever-beam technique with an instrument available from LaFouda Solutions, San Diego, CA. The saturation magnetostriction was -3.8 x 10⁻⁷. $\Delta \rho/\rho$, i.e., the difference in resistivity for saturation fields when the field is applied parallel versus when the field is applied perpendicular, was 0.27% as determined by a magnetoresistive probe available with an SHB loop tracer.

$4\pi Ms$ was $0.75 \pm 0.05$ T ($7500 \pm 500$ gauss) as determined by the SHB loop tracer available from S.H.B. Instruments, Los Angeles, CA.

The resultant film characteristics illustrate that a ternary alloy film having a composition determined by the equation Atomic % Rh = 11.63 (NiFe) atomic -49.53 is a soft magnetic material having substantially no magnetostriction.

By virtue of the disclosed composition, a magnetic material used for thin film MR heads is fabricated to have virtually zero magnetostriction and with an increase in resistivity by a factor of 4. It should be understood that the invention is not necessarily limited to the specific parameters and dimensions set forth above, and that various modifications may be made within the scope of the claims.

## Claims

1. A soft magnetic material composition, comprising:

   an alloy of nickel (Ni) and iron (Fe) wherein the ratio of nickel to iron is in the range of 4.8 to 5.6; and rhodium (Rh) in an amount defined by the equation:

   $$\text{rhodium} = 11.63 \text{ nickel/iron atomic ratio (Ni/Fe)} - 49.53 \text{ atomic percent}$$

   where all elements are designated in atomic percent and wherein the selection of an amount of atomic percent for each of said nickel, iron and rhodium provides a total atomic percent of said composition of 100 percent so that saturation magnetostriction of said composition is within +0.5 to -1.0 x 10⁻⁶.

2. A composition as recited in claim 1, wherein the atomic percent of rhodium is about 6 to about 15.

3. A magnetoresistive read transducer including a magnetoresistive layer (6) and at least one soft magnetic layer (2), said soft magnetic layer (2) comprising:

   an alloy of nickel (Ni) and iron (Fe) wherein the ratio of nickel to iron (Ni/Fe) is in the range of 4.8 to 5.6; and rhodium (Rh) in an amount defined by the equation:

   $$\text{rhodium} = 11.63 \text{ nickel/iron atomic ratio (Ni/Fe)} - 49.53 \text{ atomic percent}$$

   where all elements are desigiiated in atomic percent and wherein the selection of an amount of atomic percent for each of said nickel, iron and rhodium provides a total atomic percent of said composition of 100 percent so that saturation magnetostriction of said composition is within +0.5 to -1.0 x 10⁻⁶ and the resistivity of said soft magnetic layer is about four times greater than that of said magnetoresistive layer.

4. A transducer as recited in claim 3, wherein the atomic percent of rhodium in the alloy is about 6 to about 15.

5. A method of reducing the corrosion rate of a nickel-iron alloy while maintaining magnetostriction within +0.5 to -1 x 10⁻⁶ comprising simultaneously depositing nickel (Ni), iron (Fe) and rhodium (Rh) in amounts defined by the equation:

   $$\text{rhodium} = 11.63 \text{ nickel/iron atomic ratio (Ni/Fe)} - 49.53 \text{ atomic percent}$$

   where all deposited elements are designated in atomic percent, and wherein the selection of an amount of atomic percent for each of said nickel, iron and rhodium provides a total atomic percent of said composition of 100 percent so that saturation magnetostriction of said composition is within +0.5 to -1.0 x 10⁻⁶.

6. A method as recited in claim 5, wherein the nickel/iron atomic ratio (Ni/Fe) in the alloy is about 4.8 to about 5.6.

**7.** A method as recited in claims 5 or 6, wherein the atomic percent of rhodium in the alloy is about 6 to about 15.

**8.** A method as recited in one of claims 5 to 7, wherein said alloy is deposited by sputter deposition within a range of 0.66 - 4.0 Pa (5-30 milliTorr) Argon pressure, a substrate bias of zero to -100 volts and a deposition rate between 0.1 - 0.5 nm (1-5 Angstroms) per second.

**9.** A method as recited in one of claims 5 to 8, wherein said alloy is deposited by simultaneous evaporation, by e-beam heating or thermal heating of three separate evaporation sources including rhodium, nickel and iron, at base pressures less than $6.66 \times 10^{-4}$ Pa ($5 \times 10^{-6}$ Torr) at individual evaporation rates consistent with Rh = 11.63 nickel/iron atomic ratio (Ni/Fe) - 49.53 atomic percent.

**Patentansprüche**

**1.** Weichmagnet-Materialzusammensetzung, mit:

einer Legierung aus Nickel (Ni) und Eisen (Fe), wobei das Verhältnis von Nickel zu Eisen im Bereich von 4,8 bis 5,6 liegt; und Rhodium (Rh) in einer Menge, die durch die Gleichung bestimmt ist:

$$\text{Rhodium} = 11{,}63 \text{ Nickel/Eisen-Atomverhältnis (Ni/Fe)} - 49{,}53 \text{ Atomprozent}$$

wobei alle Elemente in Atomprozent bestimmt sind und wobei die Auswahl eines Atomprozentsatzes für jedes von Nickel, Eisen und Rhodium zu einem Gesamtatomprozentsatz der Zusammensetzung von 100% führt, so daß die Sättigungsmagnetostriktion der Zusammensetzung innerhalb von +0,5 bis $-1{,}0 \times 10^{-6}$ liegt.

**2.** Zusammensetzung nach Anspruch 1, wobei der Atomprozentsatz von Rhodium ungefähr 6 bis ungefähr 15 ist.

**3.** Magnetoresistiver Leseübertrager, der eine magnetoresistive Schicht (6) und zumindest eine Weichmagnetschicht (2) umfaßt, wobei die Weichmagnetschicht (2) umfaßt:

eine Legierung aus Nickel (Ni) und Eisen (Fe), wobei das Verhältnis von Nickel zu Eisen (Ni/Fe) im Bereich von 4,8 bis 5,6 liegt; und Rhodium (Rh) in einer Menge, die durch die Gleichung bestimmt ist:

$$\text{Rhodium} = 11{,}63 \text{ Nickel/Eisen-Atomverhältnis (Ni/Fe)} - 49{,}53 \text{ Atomprozent}$$

wobei alle Elemente in Atomprozent bestimmt sind und wobei die Auswahl eines Atomprozentsatzes für jedes von Nickel, Eisen und Rhodium zu einem Gesamtatomprozentsatz der Zusammensetzung von 100% führt, so daß die Sättigungsmagnetostriktion der Zusammensetzung innerhalb von +0,5 bis $-1{,}0 \times 10^{-6}$ liegt und der spezifische elektrische Widerstand der Weichmagnetschicht ungefähr viermal größer ist als der der magnetoresistiven Schicht.

**4.** Übertrager nach Anspruch 3, wobei der Atomprozentsatz von Rhodium in der Legierung ungefähr 6 bis ungefähr 15 ist.

**5.** Verfahren zur Reduzierung der Korrisionsrate einer Nickel-Eisen-Legierung, wobei die Magnetostriktion innerhalb von +0,5 bis $-1 \times 10^{-6}$ gehalten wird, welches das gleichzeitige Ablagern von Nickel (Ni), Eisen (Fe) und Rhodium (Rh) in Mengen umfaßt, die durch die Gleichung festgelegt sind:

$$\text{Rhodium} = 11{,}63 \text{ Nickel/Eisen-Atomverhältnis (Ni/Fe)} - 49{,}53 \text{ Atomprozent,}$$

wobei alle abgelagerten Elemente in Atomprozent bestimmt sind und wobei die Auswahl eines Atomprozentsatzes für jedes von Nickel, Eisen und Rhodium zu einem Gesamtatomprozentsatz der Zusammensetzung von 100% führt, so daß die Sättigungsmagnetostriktion der Zusammensetzung innerhalb von +0,5 bis $-1{,}0 \times 10^{-6}$ liegt.

**6.** Verfahren nach Anspruch 5, wobei das Atomverhältnis von Nickel/Eisen (Ni/Fe) in der Legierung ungefähr 4,8 bis ungefähr 5,6 ist.

7. Verfahren nach Anspruch 5 oder 6, wobei der Atomprozentsatz von Rhodium in der Legierung ungefähr 6 bis ungefähr 15 ist.

8. Verfahren nach einem der Ansprüche 5 bis 7, wobei die Legierung durch Sputter-Ablagerungen innerhalb eines Bereichs von 0,66 bis 4,0 Pa (5-30 Millitorr) Argon-Druck, einer Substratvorspannung von 0 bis -100 V und einer Ablagerungsrate zwischen 0,1 bis 0,5 nm (1 bis 5 Angström) pro Sekunde abgelagert wird.

9. Verfahren nach einem der Ansprüche 5 bis 8, wobei die Legierung durch gleichzeitiges Verdampfen, durch e-Strahlheizen oder thermisches Heizen von drei separaten Verdampfungsquellen, die Rhodium, Nickel und Eisen enthalten, bei Basisdrücken, die geringer sind als $6,66 \times 10^{-4}$ Pa ($5 \times 10^{-6}$ Torr), bei individuellen Verdampfungsraten aufgebracht wird, die mit Rh = 11,63 Nickel/Eisen-Atomverhältnis (Ni/Fe) -49,53 Atomprozent vereinbar sind.

## Revendications

1. Composition de matériau magnétique doux, comportant :
   un alliage de nickel (Ni) et de fer (Fe) dans lequel le rapport nickel sur fer est dans la plage allant de 4,8 à 5,6, et de rhodium (Rh) dans une quantité définie par l'équation: pourcentage atomique de rhodium = 11,63 rapport atomique nickel/fer (Ni/Fe) - 49,53 où tous les éléments sont indiqués en pourcentage atomique, et dans laquelle la sélection de la valeur du pourcentage atomique pour chacun parmi le nickel, le fer et le rhodium assure un pourcentage atomique total de ladite composition de 100 pour cent de sorte que la magnétostriction de saturation de ladite composition est située dans la plage allant de + 0,5 à - $1,0 \times 10^{-6}$.

2. Composition selon la revendication 1, dans laquelle le pourcentage atomique du rhodium est d'environ 6 à environ 15.

3. Transducteur de lecture nagnétorésistif comportant une couche magnétorésistive (6) et au moins une couche magnétique douce (2), ladite couche magnétique douce (2) comportant : un alliage de nickel (Ni) et de fer (Fe) dans lequel le rapport du nickel sur le fer (Ni/Fe) est dans la plage de 4,8 à 5,6, et le rhodium (Rh) est dans une quantité définie par l'équation : pourcentage atomique de rhodium = 11,63 rapport atomique de nickel/fer (Ni/Fe) - 49,53, où tous les éléments sont désignés en pourcentage atomique et dans laquelle la sélection de la valeur du pourcentage atomique pour chacun parmi le nickel, le fer et le rhodium fournit un pourcentage atomique total de ladite composition de 100 pour cent de sorte que la magnétostriction de saturation de ladite composition est située dans la plage allant de + 0,5 à - $1,0 \times 10^{-6}$ et la résistivité de ladite couche magnétique douce est d'environ quatre fois plus grande que celle de ladite couche magnétorésistive.

4. Transducteur selon la revendication 3, dans lequel le pourcentage atomique de rhodium dans l'alliage est d'environ 6 à environ 15.

5. Procédé de réduction du taux de corrosion d'un alliage nickel-fer tout en maintenant la magnétostriction entre +0,5 et - $1,0 \times 10^{-6}$ consistant à déposer simultanément du nickel (Ni), du fer (Fe) et du rhodium (Rh) selon des quantités définies par l'équation : pourcentage atomiquc de rhodium = 11,63 rapport atomique de nickel/fer (Ni/Fe) - 49,53, où tous les éléments sont désignés en pourcentage atomique et dans laquelle la sélection de la valeur du pourcentage atomique de chacun parmi le nickel, le fer et le rhodium fournit un pourcentage atomique total de ladite composition de 100 pour cent de sorte que la magnétostriction de saturation de ladite composition est située entre + 0,5 et - $1,0 \times 10^{-6}$.

6. Procédé selon la revendication 5, dans lequel le rapport atomique nickel/fer (Ni/Fe) dans l'alliage est d'environ 4,8 à environ 5,6.

7. Procédé selon la revendication 5 ou 6, dans lequel le pourcentage atomique du rhodium dans l'alliage est d'environ 6 à environ 15.

8. Procédé selon l'une quelconque des revendications 5 à 7, dans lequel ledit alliage est déposé par pulvérisation cathodique dans une plage de pression d'argon de 0,66 à 4,0 Pa (5 à 30 milliTorr), une polarisation de substrat de zéro à - 100 volts et une vitesse de dépôt entre 0,1 et 0,5 nm par seconde (1 à 5 Angströms par seconde).

9. Procédé selon l'une quelconque des revendications 5 à 8, dans lequel ledit alliage est déposé par évaporation simultanée, par chauffage par faisceau d'électrons ou par chauffage thermique de trois sources d'évaporation séparées comportant du rhodium, du nickel et du fer, à des pressions de base inférieures à $6,66 \times 10^{-4}$ Pa ($5 \times 10^{-6}$ Torr) à des vitesses d'évaporation individuelles compatibles avec pourcentage atomique de Rh = 11,63 rapport atomique nickel/fer (Ni/Fe) - 49,53.

Fig 1